# EUROPEAN PATENT APPLICATION

(11) **EP 2 549 745 A2**
(43) Date of publication of application: **23.01.2013**
(21) Application number: 12155769.8
(22) Date of filing: 16.02.2012
(51) Int. Cl.: H04N 5/3745

(54) **Method and image sensor having pixel structure for capturing depth image and color image**

(30) Priority: 22.07.2011 KR 20110073022
(71) Applicant: Samsung Electronics Co., Ltd., Suwon-si, Gyeonggi-do, 443-742 (KR)
(72) Inventor: Kim, Seong Jin, 446-712 Gyeonggi-do (KR)
(74) Representative: Grootscholten, Johannes A.M.

(57) **Abstract**

An image sensor having a pixel structure for capturing a depth image and a color image. The image sensor has a pixel structure that shares a floating diffusion (FD) node and optionally also a readout circuit, and operates with different pixel structures, according to a depth mode and a color mode. To this end at least some pixels of the N-number of pixels share at least a floating diffusion (FD) node (101; 501) with at least one of the other pixels of the N-number of pixels, Optionally also a readout circuit is shared.

## Description

### BACKGROUND

### 1. Field

Example embodiments of the following description relate to an image sensor having a pixel structure for capturing a depth image and a color image, and more particularly, to an image sensor having a pixel structure including pixels sharing a floating diffusion (FD) node.

### 2. Description of the Related Art

In order to capture a 3-dimensional (3D) image of an object, a color image and a depth image of the object both need to be extracted. A conventional image capturing apparatus extracts only a color image of an object and therefore is limited in obtaining a 3D image.

To overcome such a limitation, a time of flight (TOF) method has been used to extract a depth image of an object. The TOF method determines a travel time of light by emitting light onto the object and detecting the light reflected from the object.

Pixels generally used in a depth camera for extracting the depth image range in size between approximately 30 micrometers (µm) and 40 µm. Pixels generally used in a color camera for extracting the color image range in size between approximately 1.4 µm and 3.6 µm.

Since both the depth image and the color image are necessary for producing a 3D image, a pixel size needs to be reduced for extraction of both the depth image and the color image. However, when the pixel size is reduced, a size of a photodiode included in a pixel is also reduced. As a result, sensitivity of the photodiode is reduced.

Accordingly, there is a desire for a pixel structure capable of extracting a depth image and a color image, simultaneously, while maintaining the pixel size to the extent possible.

### SUMMARY

The foregoing and/or other aspects are achieved by providing an image sensor, the sensor including an N-number of pixels, wherein at least some of the N-number of pixels share a floating diffusion (FD) node and optionally also a readout circuit, which is preferably connected to the FD node, with at least one of the other pixels of the N-number of pixels.

The foregoing and/or other aspects are also achieved by providing an image sensor, wherein at least some of the N-number of pixels share a FD node with a first neighboring pixel located on the left and share a second FD node with a second FD node with a second neighboring pixel located on the right.

The foregoing and/or other aspects are also achieved by providing an image sensor wherein at least some of the N-number of pixels share a first FD node with a first neighboring pixel, the FD node being located below the first neighboring pixel, and shares a second FD node with a second neighboring pixel, the second FD node being located above the second neighboring pixel.

The foregoing and/or other aspects are also achieved by providing an image sensor, wherein at least some of the N-number of pixels share FD nodes located on both sides with at least one of the other pixels of the N-number of pixels.

The foregoing and/or other aspects are also achieved by providing an image sensor, the sensor including a control circuit, wherein the control circuit generates first binning images by binning output images output from a unit number of pixels in a charge domain, and generates second binning images by binning the first binning images in an analog domain.

The foregoing and/or other aspects are also achieved by providing a method for capturing a depth image and a color image, the method including providing an N-number of pixels; sharing readout and FD nodes between pixels of the N-number of pixels; and providing a color mode to capture a color image and a depth mode to capture a depth image, wherein both modes are executed using a same pixel structure.

According to the example embodiments, the fill factor may be increased through sharing of a transistor for readout and floating diffusion (FD) nodes among pixels. Therefore, a sense of color and accuracy of depth may be maintained.

According to the example embodiments, in a depth mode, a pixel is firstly binned in a charge domain and secondly binned in an analog domain. As a result, accuracy of depth may be increased.

Additional aspects, features, and/or advantages of example embodiments will be set forth in part in the description which follows and, in part, will be apparent from the description, or may be learned by practice of the disclosure.

### BRIEF DESCRIPTION OF THE DRAWINGS

These and/or other aspects and advantages will become apparent and more readily appreciated from the following description of the example embodiments, taken in conjunction with the accompanying drawings of which:
FIG. 1 illustrates a structure of a 4-shared color/depth pixel, according to example embodiments;
FIG. 2 illustrates a layout of the pixel structure of FIG. 1;
FIG. 3 illustrates the pixel structure in a color mode, according to example embodiments;
FIG. 4 illustrates the pixel structure in a depth mode, according to example embodiments;
FIG. 5 illustrates a 4 x 2 pixel structure that shares a floating diffusion (FD) node with a neighboring pixel, according to example embodiments;
FIG. illustrates a first layout of a 4 x 4 pixel structure that shares an FD node with a neighboring pixel in a color mode, according to example embodiments;
FIG. 7 illustrates a first layout of a 4 x 4 pixel structure that shares an FD node with a neighboring pixel in a depth mode, according to example embodiments;
FIG. 8 illustrates a second layout of a 4 x 4 pixel structure that shares an FD node with a neighboring pixel in a color mode, according to example embodiments;
FIG. 9 illustrates a second layout of a 4 x 4 pixel structure that shares an FD node with a neighboring pixel in a depth mode, according to example embodiments;
FIG. 10 illustrates a circuit for pixel binning in an analog domain, according to example embodiments; and
FIG. 11 illustrates hierarchical binning where pixel binning in a charge domain and pixel binning in an analog domain are sequentially performed.

### DETAILED DESCRIPTION

Reference will now be made in detail to example embodiments, examples of which are illustrated in the accompanying drawings, wherein like reference numerals refer to the like elements throughout. Example embodiments are described below to explain the present disclosure by referring to the figures.

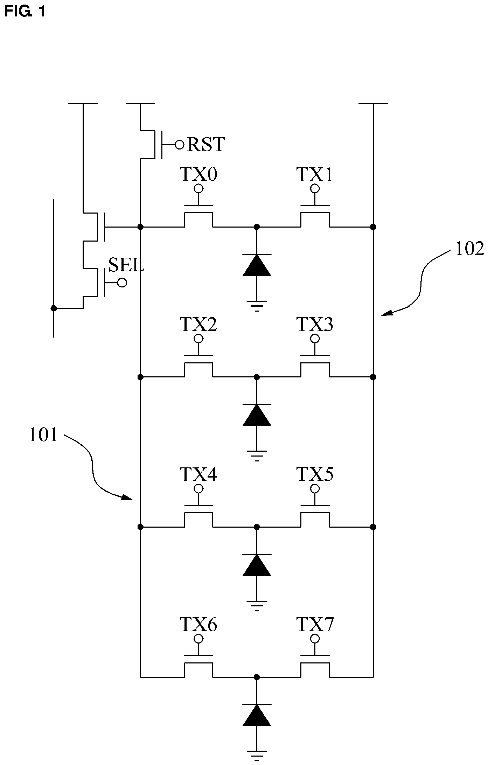

FIG. 1 illustrates a structure of a 4-shared color/depth pixel according to example embodiments.

Referring to FIG. 1, an image sensor includes four pixels, each of which includes two transfer gates. Also, each pixel may connect three transistors, that is, a reset (RST) transistor, a select (SEL) transistor, and a source follower (SF) transistor.

In FIG. 1, a first pixel includes transfer gates Tx0 and TX1 and a second pixel includes transfer gates TX2 and TX3. In the same manner, a third pixel includes transfer gates TX4 and TX5 while a fourth pixel includes transfer gates TX6 and TX7. Accordingly, the image sensor shown in FIG. 1 represents a 4 x 1 pixel structure.

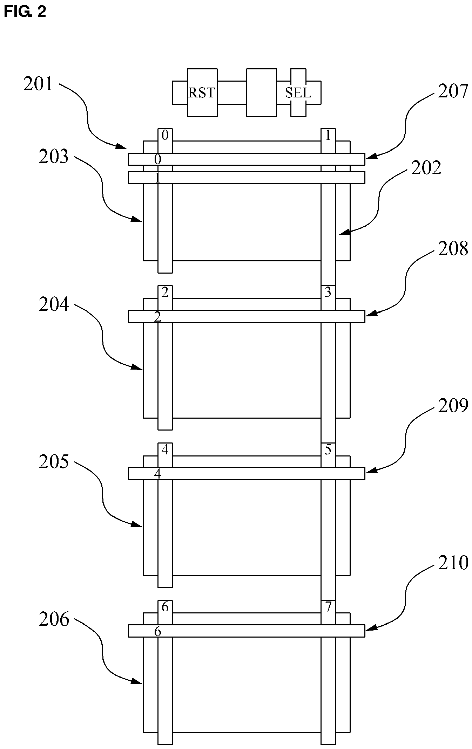

The four pixels aforementioned share a single readout circuit 102. The pixels are selected according to a signal input through the SEL transistor. In addition, the four pixels aforementioned share a floating diffusion (FD) node 101. An operation of the image sensor of FIG. 1 will be described in detail with reference to FIG. 2.

FIG. 2 illustrates a layout of the pixel structure of FIG. 1.

In FIG. 2, a first pixel 203 includes a transfer gate 0 and a transfer gate 1. A second pixel 204 includes a transfer gate 2 and a transfer gate 3. A third pixel 205 includes a transfer gate 4 and a transfer gate 5. Also, a fourth pixel 206 includes a transfer gate 6 and a transfer gate 7.

In a color mode, only transfer gates TX 2n receive input signals so that the respective pixels operate independently. That is, only the transfer gates 0, 2, 4, and 6 are operated. Therefore, the first pixel 203, the second pixel 204, the third pixel 250, and the fourth pixel 206 are controlled by different signals.

In a depth mode, only transfer gates TX 2n+1 receive input signals. That is, all of the transfer gates 0 to 7 are operated. In this case, since the transfer gates TX 2n+1 are shared by the first pixel 203, the second pixel 204, the third pixel 250, and the fourth pixel 206, all those pixels are controlled by the same signal. That is, since the transfer gates 1, 3, 5 and 7 are operable by the same signal, the first pixel 203, the second pixel 204, the third pixel 250, and the fourth pixel 206 may share the same row.

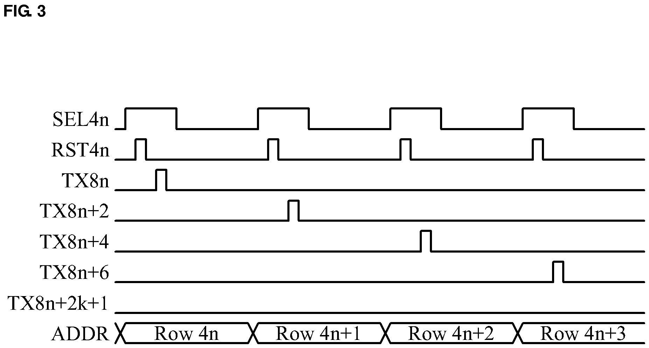

FIG. 3 illustrates a color mode of a pixel structure, according to example embodiments.

Referring to FIG. 3, in the color mode, a signal being inputted to a pixel represents a rolling shutter operation. During the time of reading out lines of the respective pixels, transfer gates are connected, and the charges collected to a photodiode of each pixel are transferred to a FD node.

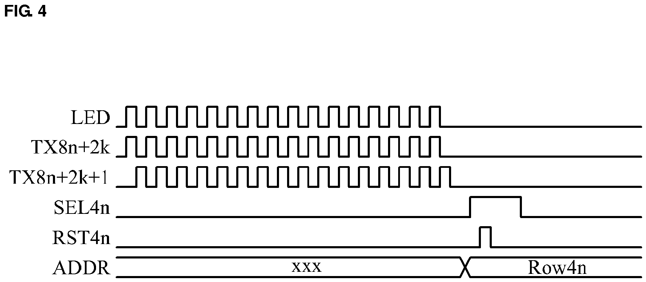

FIG. 4 illustrates a depth mode of the pixel structure, according to example embodiments.

Referring to FIG. 4, a light emitting diode (LED) signal and a transfer gate (TX) signal are synchronized in the depth mode. In this case, the TX signal is globally operated. Charges are integrated during an integration time that outputs a signal modulated by an LED. After that, the charges are read out row by row in a similar manner to the color mode.

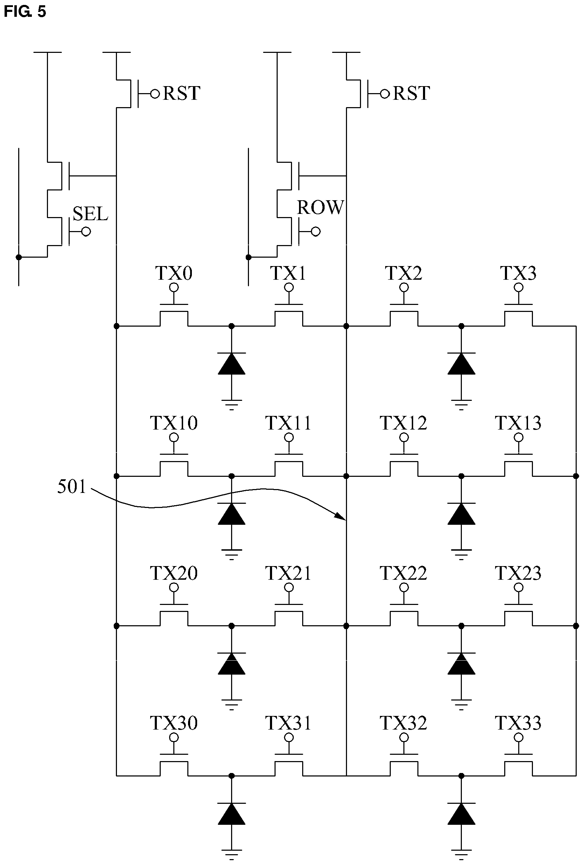

FIG. 5 illustrates a 4 x 2 pixel structure that shares an FD node 501 with a neighboring pixel, according to example embodiments.

The image sensor having the 4 x 2 pixel structure shown in FIG. 5 includes two 4 x 1 pixel structures of FIG. 1. The image sensor of FIG. 5 may include four pixels as in FIG. 1, the four pixels sharing an RST transistor, a SEL transistor, and an SF transistor.

In this scenario, according to the image sensor shown in FIG. 5, since two pixels share the single FD node 501, the fill factor may be increased. In addition, signals being applied to the FD node 501 may be read out simultaneously.

In a color mode, the image sensor may select a green (G) column or a red/blue (R/B) column according to the control of a transfer gate. In a depth mode, the image sensor may be converted to an 8-shared structure where eight pixels share the FD node 501.

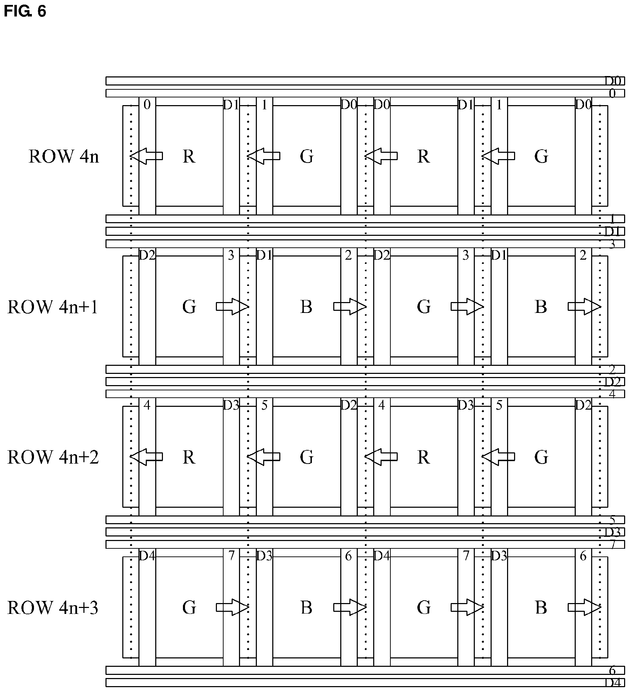

FIG. 6 illustrates a first layout of a 4 x 4 pixel structure that shares an FD node with a neighboring pixel in a color mode, according to example embodiments.

FIG. 6 shows a transfer direction of charges in an image sensor having the 4 x 4 pixel structure in the color mode. Referring to FIG. 6, transfer gates may be divided into gates denoted by 0 to 7 and gates denoted by D0 to D4. Only the transfer gates 0 to 7 are operated in the color mode. A dotted line in FIG. 6 denotes FD nodes in a shared state.

When the transfer gates 0 and 1 are operated first, charges of a red pixel of a row 4n are transferred to a left FD node and charges of a green pixel of the row 4n are transferred also to the left FD node. When the transfer gates 2 and 3 are operated to read out pixel values of a row 4n+1, charges of a green pixel and a blue pixel of the row 4n+1 are transferred to a right FD node so that the readout operation is sequentially performed.

In this case, the reason for transferring the charges of the pixels of the row 4n and row 4n+1 to the FD nodes in different directions is to minimize a mismatch between a Gr pixel and a Gb pixel. The image sensor may have alternate charge transfer directions to transfer the charges of the Gr pixel and the Gb pixel to the same FD node. That is, according to the image sensor shown in FIG. 6, sensitivity of the image sensor may be increased through sharing of the FD nodes. Additionally, a sense of color may be increased since an R/B color channel and a G color channel are separated.

Referring to FIG. 6, the image sensor may bind FD nodes of the green pixels located in different columns into one by controlling operations of transfer gates according to the row.

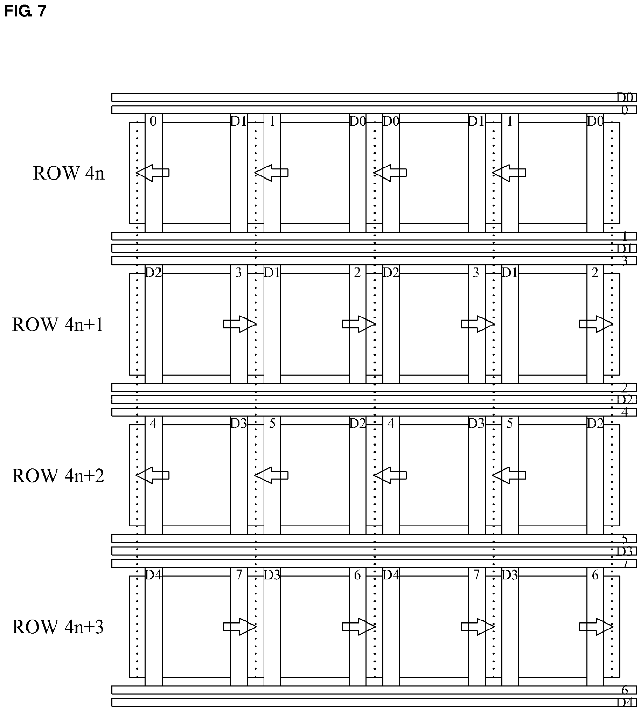

FIG. 7 illustrates a first layout of a 4 x 4 pixel structure that shares an FD node with a neighboring pixel in a depth mode, according to example embodiments.

In the depth mode, transfer gates 0 to 7 and transfer gates D0 to D4 all operate. Therefore, all sensors included in the image sensor are simultaneously operated so that depth images are collected.

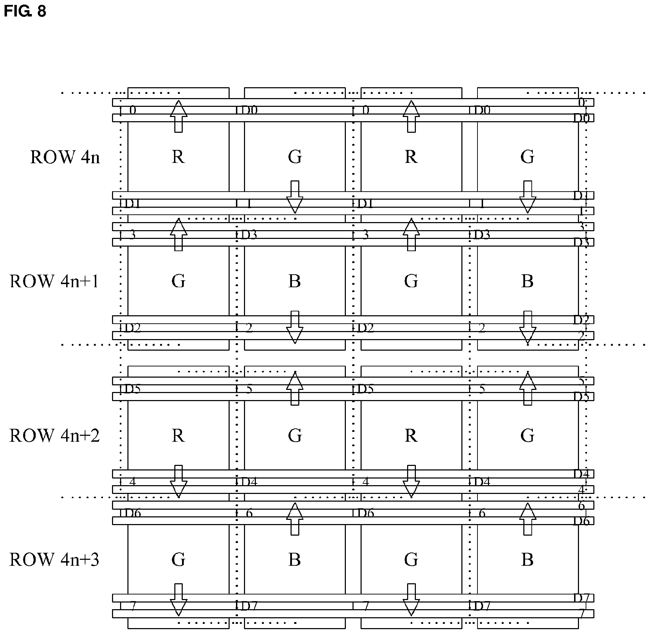

FIG. 8 illustrates a second layout of a 4 x 4 pixel structure that shares an FD node with a neighboring pixel in a color mode, according to example embodiments.

The 4 x 4 pixel structure of FIG. 8 is different from the 4 x 4 pixel structure of FIG. 6 in that charges are transferred in a lateral direction in FIG. 6, whereas, charges are transferred in a vertical direction in FIG. 8. However, the operating principles are the same. That is, transfer gates 0 to 7 are operated in the color mode. As in FIG. 6, a dotted line denotes FD nodes being shared.

In FIG. 8, when the transfer gates 0 and 1 are operated, charges of each red pixel corresponding to a row 4n are transferred to an FD node located above. In addition, charges of each green pixel corresponding to the row 4n are transferred to an FD node located below.

When transfer gates 2 and 3 are operated to read out pixel values corresponding to a next row, that is, row 4n+1, charges of each green pixel are transferred to the FD node located above, while charges of each blue pixel are transferred to the FD node located below.

According to FIG. 8, since operations of the transfer gates are controlled according to the row, FD nodes of green pixels located on different columns may be bound into one.

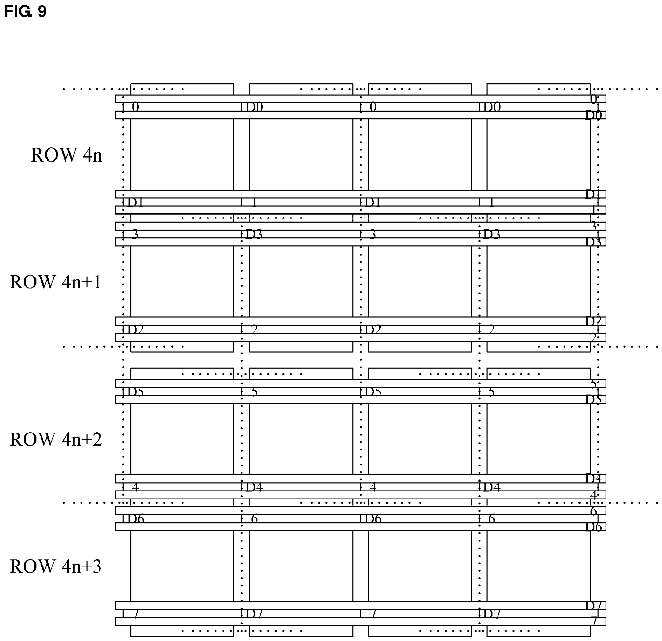

FIG. 9 illustrates a second layout of a 4 x 4 pixel structure that shares an FD node with a neighboring pixel in a depth mode, according to example embodiments.

In the depth mode, transfer gates 0 to 7 and transfer gates D0 to D7 are all operated. In this case, all sensors included in the image sensor are operated so that depth images are collected.

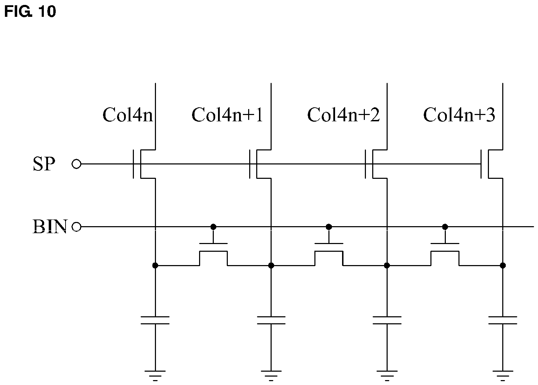

FIG. 10 illustrates a circuit for pixel binning in an analog domain according to example embodiments.

The circuit shown in FIG. 10 operates as follows.

When an (SP) signal is ON, respective column values are stored in a capacitor. When the SP signal is OFF, a binning (BIN) signal is ON, so that charges stored in four capacitors are averaged, thereby achieving a binning effect.

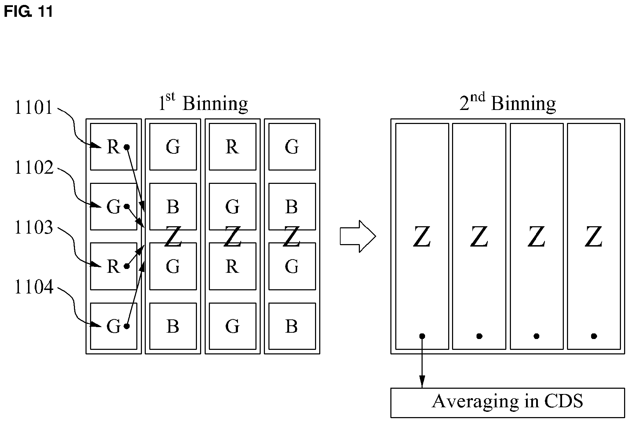

FIG. 11 illustrates hierarchical binning where pixel binning in a charge domain and pixel binning in an analog domain are sequentially performed.

In FIG. 11, images sensed by pixels 1101, 1102, 1103, and 1104 are first binned in the charge domain and indicated by one "Z." As a non-limiting example, an image sensor having a 4 x 1 pixel structure may be set as one unit and indicated by one "Z." According to the embodiments of FIG. 11, the image sensor having the 4 x 1 pixel structure may show a total of four "Zs". According to other embodiments, an image sensor having a 4 x 2 pixel structure may be set as one unit.

In the analog domain, the four "Zs" derived from the image sensor as one unit may be binned and indicated by one large "Z." That is, an image indicated in the analog domain shows that the images shown in 16 pixels in the charge domain are all binned. Since a circuit operation for the analog binning has been described in detail with reference to FIG. 10, a detailed description will be omitted for conciseness.

The methods according to the above-described example embodiments may be recorded in non-transitory computer-readable media including program instructions to implement various operations embodied by a computer. The media may also include, alone or in combination with the program instructions, data files, data structures, and the like. The program instructions recorded on the media may be those specially designed and constructed for the purposes of the example embodiments, or they may be of the kind well-known and available to those having skill in the computer software arts.

The embodiments can be implemented in computing hardware (computing apparatus) and/or software, such as (in a non-limiting example) any computer that can store, retrieve, process and/or output data and/or communicate with other computers. The results produced can be displayed on a display of the computing hardware. A program/software implementing the embodiments may be recorded on non-transitory computer-readable media comprising computer-readable recording media. Examples of the computer-readable recording media include a magnetic recording apparatus, an optical disk, a magneto-optical disk, and/or a semiconductor memory (for example, RAM, ROM, etc.). Examples of the magnetic recording apparatus include a hard disk device (HDD), a flexible disk (FD), and a magnetic tape (MT). Examples of the optical disk include a DVD (Digital Versatile Disc), a DVD-RAM, a CD-ROM (Compact Disc - Read Only Memory), and a CD-R (Recordable)/RW.

Further, according to an aspect of the embodiments, any combinations of the described features, functions and/or operations can be provided.

Moreover, the image sensor, as shown in FIGS. 1, 2, and 5-10, for example, may include at least one processor to execute at least one of the above-described units and methods.

Although example embodiments have been shown and described, it would be appreciated by those skilled in the art that changes may be made in these example embodiments without departing from the principles of the disclosure, the scope of which is defined in the appended claims and equivalents thereof.

## Claims

1. An image sensor, the sensor comprising:
an N-number of pixels,
CAHRACTERIZED IN THAT
at least some pixels of the N-number of pixels share at least a floating diffusion (FD) node (101; 501) with at least one of the other pixels of the N-number of pixels.

2. The image sensor of claim 1, wherein each pixel, from the N-number of pixels, connects three transistors, the transistors being a reset transistor (RST), a select transistor (SEL), and a source follower transistor (SF).

3. The image sensor of claim 1 or 2, wherein at least some pixels of the N-number of pixels are inputted with respectively different input signals in a color mode, and pixels of the N-number of pixels are inputted with the same input signal in a depth mode.

4. The image sensor of a preceding claim, wherein the N-number of pixels construct a 4 x 1 pixel structure that shares the FD node (101; 501) and the readout circuit (102).

5. The image sensor of a preceding claim, wherein in the color mode, while reading out lines of respective pixels, transfer gates are connected and corresponding charges, which are collected by a photodiode of each pixel, are transferred to the shared FD node (101; 501).

6. The image sensor of claim 1, wherein pixels of the N-number of pixels share a first floating diffusion (FD) node with a first neighboring pixel located on the left and share a second FD node with a second neighboring pixel located on the right.

7. The image sensor of a preceding claim, wherein pixels of the N-number of pixels share a first floating diffusion (FD) node (101; 501) with a first neighboring pixel, the first FD node (101, 501) being located below the first neighboring pixel, and shares a second FD node (101, 501) with a second neighboring pixel, the second FD node (101, 501) being located above the second neighboring pixel.

8. The image sensor of a preceding claim, wherein pixels of the N-number of pixels share floating diffusion (FD) nodes (101, 501) located on both ends of each of the N-number of pixels, with at least one of the other pixels of the N-number of pixels.

9. The image sensor of a preceding claim, wherein the N-number of pixels construct a 4 x 2 pixel structure in a color mode.

10. The image sensor of a preceding claim, wherein the image sensor controls the N-number of pixels to transfer charges of pixels located on different lines to FD nodes (101, 501) located in different directions, in a color mode.

11. The image sensor of a preceding claim, wherein eight pixels of the N-number of pixels share one FD node (101, 501) in a depth mode.

12. The image sensor of a preceding claim, further comprising:
a control circuit, which generates first binning images by binning output images outputted from a unit number of pixels in a charge domain, and generates second binning images by binning the first binning images in an analog domain.

13. The image sensor of claim 12, wherein a unit is set as a 4 x 1 pixel structure.

14. The image sensor of claim 12, wherein a unit is set as a 4 x 2 pixel structure.

15. A method for capturing a depth image and a color image, the method comprising:
providing an N-number of pixels;
sharing readout circuits (102) and floating diffusion (FD) nodes (101, 501) between pixels of the N-number of pixels;
providing a color mode to capture a color image and a depth mode to capture a depth image; and
executing both the color mode and the depth mode using a same pixel structure.
